# EUROPÄISCHE PATENTSCHRIFT

(11) **EP 1 023 773 B1**
(45) Veröffentlichungstag und Bekanntmachung des Hinweises auf die Patenterteilung: **09.01.2002**
(21) Anmeldenummer: 98961014.2
(22) Anmeldetag: 16.10.1998
(51) Int. Cl.: H03K 17/082, G01R 15/00, G05D 15/01, F02D 41/00

(54) **SCHALTUNGSANORDNUNG ZUM REGELN DES EINEM ELEKTROMECHANISCHEN BAUTEIL IN EINEM KRAFTFAHRZEUG ZUGEFÜHRTEN STROMES**
CIRCUIT FOR REGULATING THE CURRENT SUPPLIED TO AN ELECTROMECHANICAL COMPONENT IN A MOTOR VEHICLE
CIRCUIT SERVANT A REGULER LE COURANT ACHEMINE A UN COMPOSANT ELECTROMECANIQUE DANS UN VEHICULE A MOTEUR

(30) Priorität: 17.10.1997 DE 19746056
(43) Veröffentlichungstag der Anmeldung: 02.08.2000
(73) Patentinhaber: SIEMENS AKTIENGESELLSCHAFT, 80333 München (DE)
(72) Erfinder: HAUER, Gerald, D-93180 Deuerling (DE)
(86) Internationale Anmeldenummer: DE9803038
(87) Internationale Veröffentlichungsnummer: WO9921279

(56) Entgegenhaltungen:
- DE-A- 2 630 958
- DE-A- 3 811 670
- DE-A- 4 223 338
- US-A- 4 264 961
- US-A- 4 612 895
- US-A- 4 836 174
- US-A- 5 159 532

## Beschreibung

Schaltungsänordnung zum Regeln des einem elektromechanischen Bauteil in einem Kraftfahrzeug zugeführten Stromes

Die Erfindung betrifft eine Schaltungsanordnung gemäß dem Oberbegriff des Patentanspruchs 1.

Eine derartige Schaltungsanordnung dient zum Regeln des einem elektromechanischen Bauteil in einem Kraftfahrzeug zugeführten Stromes, insbesondere des Spulenstromes für ein Hydraulikdruck-Regelventil eines automatischen Kraftfahrzeuggetriebes. Sie weist einen Schaltungsträger, der Leiterbahnen und Bauelemente zum Steuern des elektromechanischen Bauteiles enthält, sowie einen Strommeßwiderstand auf, dessen Signal bei der Stromregelung ausgewertet wird.

Bekannt ist eine Einrichtung zum Erfassen eines Verbraucher-Stroms (DE 42 23 338 A1), und zwar für einen Regler mit Überlastschutz. Ein von einem Strommeßwiderstand abgeleitetes Signal und ein Bezugssignal werden einen Operationsverstärker zugeführt. Der Strommeßwiderstand ist als Leiterbahn einer gedruckten Schaltung ausgebildet. Das Bezugssignal wird über eine weitere Leiterbahn an den zweiten Eingang des Operationsverstärkers gelegt. Beide Leiterbahnen sind gleich aufgebaut und stehen in guten thermischen Kontakt. Dadurch wird der Verbraucherstrom temperaturkompensiert erfaßt.

Bei einer Fehlerkompensation für Meßgeräte werden deren Meßwerte in einem Mikrocomputer errechnet (DE-A-26 30 958). Dem Mikrocomputer sind Speicher zugeordnet, in denen Korrekturwerte, Korrekturkurven von Referenzgrößen und von Bauelementen, Temperaturkoeffizienten, Temperaturverlaufskurven und Alterungsraten der Referenzgrößen und Bauelemente gespeichert werden. Die Korrekturwerte werden mit einem meßgeräteeigenen Analog-Digital-Wandler gemessen und enthalten deshalb diesen Fehler mit. Die Meßgeräte registrieren die seit dem Einsatz eines Meßgeräts abgelaufene Zeit, und alle gespeicherten Korrekturwerte werden bei Berechnung der endgültigen Meßwerte berücksichtigt. Auch das Ausgangssignal eines Temperaturfühlers und die gespeicherten Temperaturkoeffizienten und - kurven werden bei der Berechnung berücksichtigt.

Bei Stromreglern, die hohen Temperaturschwankungen unterworfen sind, ist es üblich, einen Strommeßwiderstand aus Konstantan oder einer ähnlichen hochwertigen Legierung auf der die Bauelemente tragenden Seite des Schaltungsträgers aufzukleben und durch Bonddrähte zu kontaktieren. Damit ist zwar in einem weiten Temperaturbereich eine genaue Strommessung möglich, doch sind solche präzisen Strommeßwiderstände teuer.

Der Erfindung liegt die Aufgabe zugrunde, eine kostengünstige und platzsparende Schaltungsanordnung zur Stromregelung zu schaffen.

Die genannte Aufgabe wird durch die Schaltungsanordnung nach Patentanspruch 1 gelöst. Vorteilhafte Weiterbildungen sind in den Unteransprüchen niedergelegt.

Die Vorteile der Erfindung liegen insbesondere darin, daß der kostspielige Präzisionswiderstand durch einen einfachen, kostengünstigen, weil auf den Schaltungsträger aufgedruckten Strommeßwiderstand ersetzt wird. Da der Stromregler außer den Bauelementen zum Steuern der elektromechanischen Bauteile auch eine Reihe von Widerständen, die Bestandteil einer gedruckten Schaltung sind, aufweist, ergibt sich eine sehr wirtschaftliche Fertigung, da der Strommeßwiderstand gleichzeitig mit aufgedruckt werden kann. Der Aufwand für Montage und Kontaktierung des Präzisionswiderstandes entfällt, und das nötige Material ist preisgünstig. Ferner wird Montageplatz auf der die diskreten Bauelemente tragenden Oberfläche des Schaltungsträgers frei.

Andererseits liefert der gedruckte Strommeßwiderstand ausgesprochen temperaturabhängige Meßwerte, die kompensiert werden müssen. Dies wird in sehr einfacher Weise dadurch erreicht, daß das Signal des Temperatursensors oder -fühlers zur Kompensation in einem Steuergerät verwendet wird, wobei der Temperatursensor ohnehin in der Schaltungsanordnung vorhanden und insbesondere auf dem Schaltungsträger selbst aufgebracht ist.

Ein Ausführungsbeispiel der Erfindung wird nachstehend anhand der Zeichnung näher erläutert. Es zeigt:
- Figur 1: einen Schnitt durch eine erfindungsgemäße Schaltungsanordnung, und.
- Figur 2: eine schematische Darstellung eines mit einer Schaltungsanordnung gemäß Figur 1 versehenen automatischen Getriebes

Eine in einer Schnittansicht senkrecht zu ihrer flächigen Ausdehnung dargestellte Schaltungsanordnung 1 zum Regeln eines Stromes weist einen keramischen Schaltungsträger 4 auf, dessen (in der Zeichnung oben liegende) erste Seite oder Oberfläche mit diskreten Bauelementen 2, zum Beispiel "Kondensatoren, Transistoren und integrierte Schaltungen (ICs), bestückt ist, die über Leiterbahnen 5 elektrisch kontaktiert sind. Auf der unten liegenden zweiten Seite des keramischen Schaltungsträgers 4 sind Widerstände 8 in Dickschichttechnik aufgedruckt.

Der gesamte keramische Schaltungsträger 4 ist auf eine metalische Wärmeableitplatte 10 aufgeklebt. Ein Temperatursensor oder -fühler 3 ist über eine Durchkontaktierung 6 thermisch mit der Wärmeableitplatte (oder Kühlplatte) 10 gekoppelt. Er mißt somit die Temperatur der Wärmeableitplatte 10, die identisch mit der Temperatur der Widerstände 6 ist. Die Durchkontaktierung 6 ist nicht unbedingt erforderlich, da die Wärmeableitplatte 10 eine gleichmäßige Temperaturverteilung über den ganzen Schaltungsträger 4 bewirkt. Der Temperatursensor 3 sollte dann nicht zu nahe an einem viel Wärme abgebenden Bauelement 2 liegen.

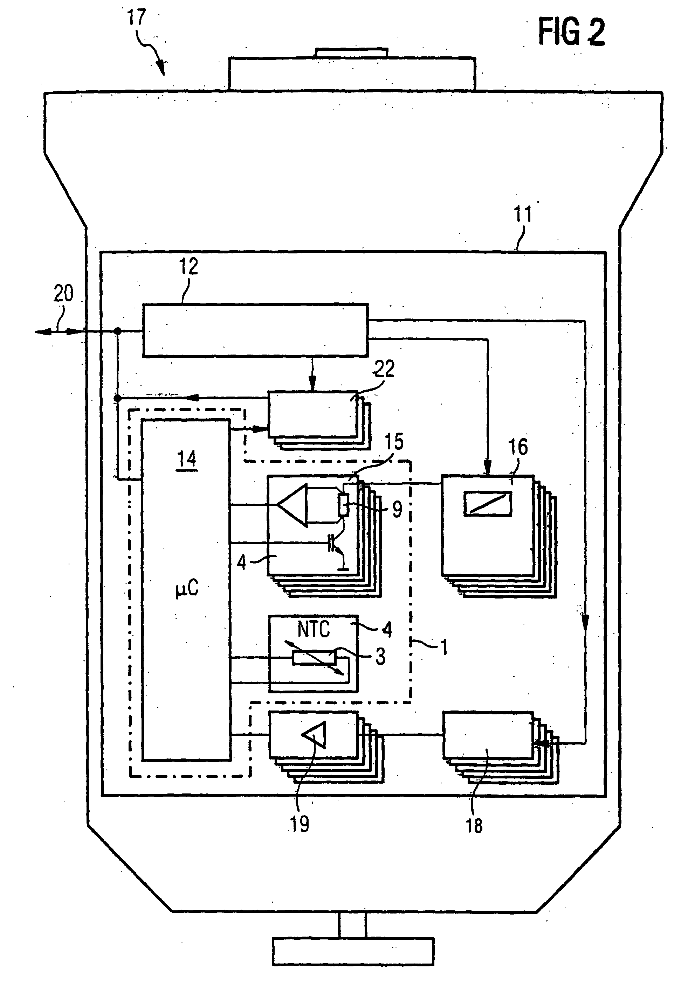

Ein automatisches Kraftfahrzeug-Getriebe 17 (Figur 2) enthält eine integrierte Getriebesteuerung 11. Einem Hydraulikventil 16 wird von einem Stromregler 15 ein Steuerstrom zugeführt. Der Stromregler 15 liegt zwischen einem Steuergerät 14 und dem Hydraulikventil 16. In der Getriebesteuerung 11 sind üblicherweise mehrere stromgeregelte Hydraulikventile 16 mit jeweils einem Stromregler 15 vorgesehen. Der dem Hydraulikventil 16 zugeführte Strom wird über einen als Shunt oder Nebenwiderstand geschalteten Strommeßwiderstand 9 in eine Spannung umgesetzt, die dem Steuergerät 14 zugeführt und dort zur Stromregelung verwendet wird. Die stromgesteuerten Hydraulikventile 16 haben eine lineare Strom-Druck-Kennlinie und sie dienen der stufenlosen Einstellung von Öldrücken in dem Getriebe 17, mit denen das Getriebe gesteuert, d. h. geschaltet oder die Getriebeübersetzung - stufenlos - eingestellt, wird.

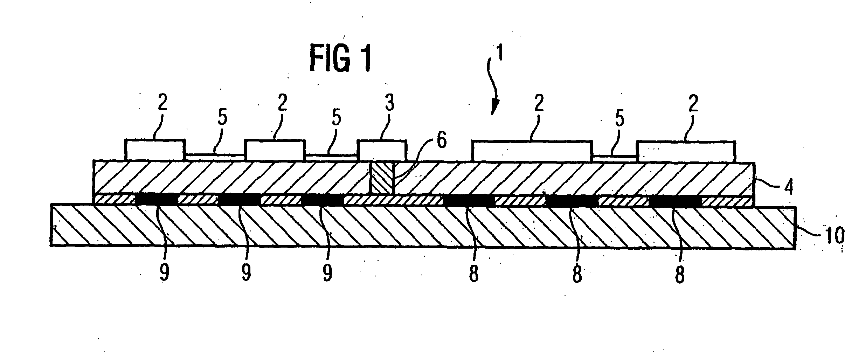

Der Temperatursensor 3 ist vorzugsweise auf dem Schaltungsträger 4 (siehe Figur 1) des Stromreglers 15 selbst angebracht. Bislang wurde auf der die Bauelemente 2 tragenden Oberfläche des keramischen Schaltungsträgers 4 ein Präzisionsmeßwiderstand als zusätzliches Bauelement 2 geklebt und elektrisch kontaktiert, wobei der entsprechende Bauplatz vorgesehen werden mußte.

Erfindungsgemäß wird ein aufgedruckter Strommeßwiderstand 9 zur Strommessung verwendet, der zusammen mit den anderen Widerständen 8 - insbesondere in Dickschichttechnik auf der Unterseite des Schaltungsträgers 4 - aufgedruckt ist. Die Darstellung in Figur 1 beruht darauf, daß der Strommeßwiderstand 9 zweifach geknickt, also S-förmig ausgebildet ist und damit in der Schnittansicht dreimal zu sehen ist. So kann an der Oberseite des keramischen Schaltungsträgers 4 auf ein separat montiertes Bauteil verzichtet und der Schaltungsträger 4 insgesamt verkleinert werden.

Der verhältnismäßig hohe temperaturbedingte Meßfehler des gedruckten Strommeßwiderstands 9 wird mit Hilfe des ohnehin vorhandenen Temperatursensors 3 in dem Steuergerät 14 korrigiert. Über den Schaltungsträger 4 - und gegebenenfalls die Durchkontaktierung 6 - sind der Strommeßwiderstand 9 und der Temperatursensor 3 thermisch gekoppelt, so daß die Temperaturangabe des Temperatursensors 3 zur Korrektur des Widerstandswertes des Stromwiderstands 9 verwendet werden kann. Sind mehrere Strommeßwiderstände 9 für mehrere Hydraulikventile 16 vorgesehen, so kann das Temperatursignal eines Temperatursensors 3 zur Korrektur aller Strommeßwiderstände 9 verwendet werden. Eine Stromversorgung 12 versorgt alle Bestandteile der Getriebesteuerung 11 und schützt sie vor Kurzschlüssen und Fehlspannungen.

Sind die auf dem keramischen Schaltungsträger 4 aufgedruckten Widerstände 8 als Dickschichtwiderstände hergestellt, so sind auch der Temperatursensor 3 und der Strommeßwiderstand 9 in vorteilhafter Weise als Dickschichtwiderstand ausgsebildet. Solche Temperatursensoren sind bekannt, beispielsweise aus IEEE Transactions und Components, Hybrides and Manufacturing Technology, Vol. CHMT-3, No. 4, December 1980, New York, USA "Thick-Film Thermistor and Its Applications" oder JP 5135908.

Ein Temperaturfehler des gedruckten Strommeßwiderstandes von über 10% kann durch die erfindungsgemäße Schaltungsanordnung soweit kompensiert werden, daß die Abweichung des zu messenden Stromes unter 1% liegt. Die Kompensation erfolgt zum Beispiel digital in einem Mikrocontroller µC des Steuergeräts 14. Die Abhängikeit des Widerstandswertes des Strommeßwiderstands 9 von der Temperatur ist in dem Mikrocontroller zum Beispiel als Kennlinie gespeichert.

Weitere Bestandteile der in das Kraftfahrzeuggetriebe integrierten Getriebesteuerung sind: Signal-Aufbereitungsschaltungen 19, in denen die von verschiedenen Sensoren 18 gelieferten Signale entstört und aufbereitet werden, bevor sie zur Auswertung in das Steuergerät 14 gelangen. Die Sensoren 18 liefern Informationen über verschiedene Drücke, Drehzahlen und Stellungen und somit über den Betriebszustand des Getriebes 17.

Das Steuergerät 14 wertet sowohl externe Befehle, die über eine Kommunikationsschnittstelle 20 eingehen, als auch die Sensorsignale aus, und erzeugt daraufhin Steuersignale. Es steuert insbesondere die Kommunikation, schaltet Relais, regelt die Hydraulikventile 16, zeichnet Betriebsdaten auf und überwacht das Getriebe 17 und die Getriebesteuerung 11.

Treiberschaltungen 22 steuern über Relais externe Verbraucher, wie zum Beispiel eine Sperre, die verhindert, daß bei nicht betätigter Bremse mit dem Wählhebel eine Fahrstufe des Getriebes eingelegt wird.

Zusamengefassend sei die Erfindung wie folgt erläutert. Die Schaltungsanordnung 1 dient zum Regeln insbesondere des Spulenstromes für ein Hydraulikdruck-Regelventil 16 eines Kraftfahrzeug-Getriebes 17. Auf einem aus einem Keramikwerkstoff hergestellten Schaltungsträger 4 sind ein als Dickschichtwiderstand ausgebildeter Strommeßwiderstand 9 und ein die Getriebeöltemperatur erfassender und mit dem Strommeßwiderstand 9 thermisch gekoppelter Temperatursensor 3 aufgebracht. Die Signale des Strommeßwiderstands 9 und des Temperatursensors 3 werden einem Steuergerät 14 zugeführt, in dem das Signal des Temperatursensors zur Kompensation des temperaturabhängigen Widerstandswerts des Strommeßwiderstands 9 verwendet wird.

### Bezugszeichen:

- 1: Schaltungsanordnung
- 2: Bauelement
- 3: Temperatursensor oder -fühler
- 4: Schaltungsträger, keramisch
- 5: Leiterbahnen
- 6: Durchkontaktierung
- 8: Widerstände, in Dichschichttechnik aufgedruckt
- 9: Strommeßwiderstand
- 10: Wärmeableitplatte, Kühlplatte
- 11: Getriebesteuerung
- 12: Strömversorgung
- 14: Steuergerät
- 15: Stromregler
- 16: Hydraulikventil
- 17: automatisches Kraftfahrzeug-Getriebe
- 18: Sensoren
- 19: Signal-Aufbereitung(sschaltung)
- 20: Kommunikatiosschnittstelle
- 22: Treiberschaltung
- µC: Mikrocontroller

## Patentansprüche

1. Schaltungsanordnung (1) zum Regeln des einem elektromechanischen Bauteil in einem Kraftfahrzeug zugeführten Stromes, insbesondere des Spulenstromes für ein Hydraulikdruck-Regelventil (16) eines automatischen Kraftfahrzeuggetriebes (17), mit einem Schaltungsträger (4), der Leiterbahnen (5) und Bauelemente (2) zum Steuern des elektromechanischen Bauteiles und einen Strommeßwiderstand (9) auf weist, dessen Signal bei der Stromregelung ausgewertet wird, **dadurch gekennzeichnet,**
- **daß** auf dem aus einem Keramikwerkstoff hergestellten Schaltungsträger (4) der als Dickschichtwiderstand ausgebildete Strommeßwiderstand (9) und ein die Getriebeöltemperatur erfassender und mit dem Strommeßwiderstand (9) thermisch gekoppelter Temperatursensor (3) aufgebracht sind, und
- **daß** die Signale des Strommeßwiderstands (9) und des Temperatursensors (3) einem Steuergerät (14) zugeführt werden, in dem das Signal des Temperatursensors (3) zur Kompensation des temperaturabhängigen Widerstandswert des Strommeßwiderstands (9) verwendet wird.

2. Schaltungsanordnung nach Anspruch 1, **dadurch gekennzeichnet, daß** auf einer Seite des keramischen Schaltungsträgers (4) die Bauelemente (2) und auf der gegenüberliegenden Seite des Schaltungsträgers der Strommeßwiderstand (9) und weitere gedruckte Widerstände (8) und aufgebracht sind.

3. Schaltungsanordnung nach einem der vorhergehenden Ansprüche, **dadurch gekennzeichnet, daß** der Temperatursensor (3) ein NTC-Widerstand ist.

4. Schaltungsanordnung nach einem der vorhergehenden Ansprüche, **dadurch gekennzeichnet, daß** ein einziger den Temperaturverlauf mehrerer Strommeßwiderstände (9) kompensierender Temperatursensor (3) vorgesehen ist.

## Claims

1. Circuit arrangement (1) for regulating the current fed to an electromechanical component in a *motor* vehicle, in particular the coil current for a hydraulic pressure regulating valve (16) of an automatic motor vehicle transmission (17), having a circuit carrier (4), which has conductor tracks (5) and components (2) for controlling the electromechanical component and a current measuring resistor (9), whose signal is evaluated during the current regulation, **characterized**
- **in that** the current measuring resistor (9) designed as a thick-film resistor and a temperature sensor (3), which detects the transmission oil temperature and is thermally coupled to the current measuring resistor (9), are applied on the circuit carrier (4) produced from a ceramic material, and
- **in that** the signals of the current measuring resistor (9) and of the temperature sensor (3) are fed to a control unit (14), in which the signal of the temperature sensor (3) is used to compensate for the temperature-dependent resistance of the current measuring resistor (9).

2. Circuit arrangement according to Claim 1, **characterized in that** the components (2) are applied on one side of the ceramic circuit carrier (4) and the current measuring resistor (9) and further printed resistors (8) are applied on the opposite side of the circuit carrier.

3. Circuit arrangement according to one of the preceding claims, **characterized in that** the temperature sensor (3) is an NTC thermistor.

4. Circuit arrangement according to one of the preceding claims, **characterized in that** a single temperature sensor (3) is provided to compensate for the temperature profile of a plurality of current measuring resistors (9).

## Revendications

1. Circuit (1) destiné à réguler, dans un véhicule automobile, le courant envoyé dans un constituant électromécanique, en particulier le courant de bobine d'une soupape de régulation (16) de la pression hydraulique d'une boîte de vitesses automatique (17) de véhicule automobile, comportant un support de circuit (4), présentant des pistes conductrices (5) et des composants (2) pour commander le constituant électromécanique, et une résistance de mesure d'intensité (9), dont le signal est interprété pour la régulation du courant,
**caractérisé:**
- **en ce que** la résistance de mesure d'intensité (9), réalisée sous la forme d'une résistance à couche épaisse, et une sonde de température (3), relevant la température d'huile de boîte de vitesses et couplée thermiquement à la résistance de mesure d'intensité (9), sont installées sur le support de circuit (4), réalisé à partir d'un matériau céramique, et
- **en ce que** les signaux de la résistance de mesure d'intensité (9) et de la sonde de température (3) sont envoyés à un appareil de commande (14), dans lequel le signal de la sonde de température (3) est utilisé pour compenser la valeur de la résistance de mesure d'intensité (9), valeur qui dépend de la température.

2. Circuit suivant la revendication 1, **caractérisé en ce que** les composants (2) sont disposés sur une face du support de circuit (4) en céramique, et la résistance de mesure d'intensité (9) et d'autres résistances imprimées (8) sont disposées sur la face opposée du support de circuit (4).

3. Circuit suivant l'une des revendications précédentes, **caractérisé en ce que** la sonde de température (3) est une résistance NTC.

4. Circuit suivant l'une des revendication précédentes, **caractérisé en ce qu'**il est prévu une unique sonde de température (3) compensant la courbe de température de plusieurs résistances de mesure d'intensité (9).
